# FASCICULE DE BREVET EUROPEEN

(11) **EP 4 473 559 B1**
(45) Date de publication et mention de la délivrance du brevet: **18.03.2026**
(21) Numéro de dépôt: 23706411.8
(22) Date de dépôt: 30.01.2023
(51) Int. Cl.: H01L 21/762

(54) **PROCEDE DE FABRICATION D'UNE STRUCTURE DE TYPE DOUBLE SEMI-CONDUCTEUR SUR ISOLANT**
VERFAHREN ZUR HERSTELLUNG EINER DOPPELTEN HALBLEITER-AUF-ISOLATOR-STRUKTUR
PROCESS FOR FABRICATING A DOUBLE SEMICONDUCTOR-ON-INSULATOR STRUCTURE

(30) Priorité: 31.01.2022 FR 2200850
(43) Date de publication de la demande: 11.12.2024
(73) Titulaire: SOITEC, 38190 Bernin (FR)
(72) Inventeur: DURET, Carine, 38190 BERNIN (FR); ECARNOT, Ludovic, 38190 BERNIN (FR); PORTA, Charlene, 38190 BERNIN (FR)
(74) Mandataire: Regimbeau
(86) Numéro de dépôt international: PCT/FR2023/050115
(87) Numéro de publication internationale: WO 2023/144495

(56) Documents cités:
- US-A1- 2001 016 401
- US-A1- 2002 182 827
- US-A1- 2012 223 419
- US-B2- 7 160 753
- MALEVILLE C ET AL: "MULTIPLE SOI LAYERS BY MULTIPLE SMART-CUT TRANSFERS", 2000 IEEE INTERNATIONAL SOI CONFERENCE PROCEEDINGS. WAKEFIELD, MA, OCT. 2 - 5, 2000; [IEEE INTERNATIONAL SOI CONFERENCE], NEW YORK, NY : IEEE, US, 2 October 2000 (2000-10-02), pages 134/135, XP001003462, ISBN: 978-0-7803-6390-8

## Description

### DOMAINE TECHNIQUE

L'invention concerne un procédé de fabrication d'une structure de type double semi-conducteur sur isolant.

### ETAT DE LA TECHNIQUE

Les structures de type semi-conducteur sur isolant sont des structures multicouches comprenant un substrat support qui est généralement en un matériau semi-conducteur tel que du silicium, une couche électriquement isolante agencée sur le substrat support, qui est généralement une couche d'oxyde telle qu'une couche d'oxyde de silicium, et une couche semi-conductrice agencée sur la couche isolante, qui est généralement une couche de silicium. De telles structures sont dites structures « Semiconductor on Insulator » en anglais (SeOI), en particulier « Silicon on Insulator » (SOI) lorsque le matériau semi-conducteur est du silicium. La couche d'oxyde se trouve entre le substrat et la couche semi-conductrice. La couche d'oxyde est alors dite « enterrée », et est appelée « BOX » pour « Buried Oxide » en anglais. Dans la suite du texte, on emploiera le terme « SOI » pour désigner d'une manière générale les structures de type semi-conducteur sur isolant.

Outre les structures SOI comprenant une couche de BOX et une couche semi-conductrice agencée sur la couche de BOX, des structures « double SOI » ont été réalisées. Les structures « double SOI » comprennent un substrat support (« handle substrate » en anglais), une première couche d'oxyde ou couche d'oxyde enterrée inférieure agencée sur le substrat support, une première couche semi-conductrice ou couche semi-conductrice inférieure agencée sur la première couche d'oxyde, une seconde couche d'oxyde ou couche d'oxyde enterrée supérieure agencée sur la première couche semi-conductrice et une seconde couche semi-conductrice ou couche semi-conductrice supérieure agencée sur la seconde couche d'oxyde. Dans cette structure de double SOI, la première couche d'oxyde et la première couche semi-conductrice constituent le premier SOI, agencé dans une partie inférieure de la structure, tandis que la seconde couche d'oxyde et la seconde couche semi-conductrice constituent le second SOI, agencé dans une partie supérieure de la structure.

Un procédé connu pour la fabrication d'une structure SOI est le procédé dit Smart Cut^{™}. Le procédé Smart Cut^{™} comprend l'implantation d'espèces atomiques, telles que de l'hydrogène (H) et/ou de l'hélium (He), afin de créer une zone de fragilisation au sein d'un substrat donneur, le collage du substrat donneur sur le substrat receveur puis le détachement du substrat donneur au niveau de la zone de fragilisation de sorte à transférer une couche mince du substrat donneur sur le substrat receveur. Le substrat donneur et le substrat receveur se présentent de préférence sous la forme de plaques de 300 mm de diamètre. Le substrat donneur est un substrat semi-conducteur préalablement oxydé en surface : les atomes de H et/ou de He sont implantés, à travers la couche d'oxyde, à une profondeur donnée dans le cœur du matériau semi-conducteur. Le collage se fait entre la surface du substrat receveur et la surface de la couche d'oxyde du substrat donneur.

Une solution proposée pour l'obtention d'un double SOI est de mettre en œuvre deux procédés Smart Cut^{™} successifs en utilisant, pour le deuxième procédé Smart Cut^{™}, le SOI obtenu suite au premier procédé Smart Cut^{™} comme substrat receveur et un second substrat semi-conducteur préalablement oxydé en surface comme substrat donneur. Dans la structure finale du double SOI, la couche d'oxyde et la couche semi-conductrice du premier SOI obtenues suite au premier procédé Smart Cut^{™} constituent respectivement la couche d'oxyde inférieure et la couche semi-conductrice inférieure. La couche d'oxyde et la couche semi-conductrice issues du second substrat donneur suite au deuxième procédé Smart Cut^{™} constituent respectivement la couche d'oxyde supérieure et la couche semi-conductrice supérieure du double SOI obtenu.

Pour une profondeur donnée de la zone de fragilisation au sein d'un substrat donneur, l'épaisseur de la couche semi-conductrice destinée à être transférée est limitée par l'épaisseur de la couche d'oxyde présente à la surface du substrat donneur. En effet, l'épaisseur maximale sur laquelle peuvent pénétrer les atomes d'hydrogène et/ou d'hélium au sein du substrat donneur recouvert de la couche d'oxyde est fixée par l'énergie maximale du dispositif d'implantation. Cette épaisseur dépend de l'épaisseur d'oxyde traversée par les atomes implantés. Elle reste typiquement de l'ordre de quelques centaines de nanomètres de silicium. Le procédé de « double Smart Cut^{™} » tel que décrit ci-dessus ne permet donc pas d'obtenir des épaisseurs qui soient grandes à la fois pour les couches semi-conductrices et les couches d'oxyde. Des structures de double SeOI présentant des épaisseurs importantes à la fois pour les couches d'oxyde et les couches de semi-conducteur (par exemple de l'ordre de quelques centaines de nanomètres chacune) sont pourtant des structures d'intérêt pour certaines applications, notamment en photonique.

En outre, l'efficacité du collage lors du second procédé Smart Cut^{™} est conditionnée par la qualité de la surface du SOI servant de substrat receveur. Des traitements de surface, comme par exemple des traitements thermiques, peuvent être mis en oeuvre préalablement au collage du second substrat donneur afin de, notamment, diminuer la rugosité de la surface du SOI servant de substrat receveur. Toutefois, à l'issue de tels traitements thermiques, une déformation de la plaque formée par le premier SOI et/ou par le double SOI peut être constatée. Les plaques sont d'autant plus sensibles à la déformation qu'elles présentent un diamètre important, notamment un diamètre de 300 mm dans les applications privilégiées. Les équipements industriels pour la fabrication et le traitement des plaques semi-conductrices sont conçus pour manipuler des plaques planes. Par ailleurs, l'utilisation d'une plaque déformée en tant que substrat receveur pour le second collage avec le second substrat donneur peut conduire à la formation de défauts lors de ce second collage, et donc à une mauvaise qualité de collage.

L'état de la technique pertinent est représenté par les documents US 2002/182827 A1, Maleville C ET AL: "Multiple SOI layers by multiple SMART-CUT transfers", 2000 IEEE International SOI conference proceedings. Wakefield, MA, Oct. 2 - 5, 2000; page 134/135, XP001003462, ISBN: 978-0-7803-6390-8 et US 7 160 753 B2, qui décrivent des procédés de fabrication de substrats multicouches semi-conducteurs sur isolant, et les documents US 2001/016401 A1 et US 2012/223419 A1, qui décrivent des procédés de contrôle des contraintes mécaniques de structures collées.

### BREVE DESCRIPTION DE L'INVENTION

Un but de l'invention est de réaliser des structures multicouches de type double semi-conducteur sur isolant telles que les épaisseurs des couches semi-conductrices et des couches électriquement isolantes soient suffisantes pour certaines applications en photonique.

Un autre but de l'invention est de limiter la déformation de la plaque à l'issue de la mise en oeuvre éventuelle de traitements thermiques, notamment de traitements de surface, au cours du procédé de fabrication de ladite structure multicouche de type double semi-conducteur sur isolant.

A cet effet, l'invention propose un procédé de fabrication d'une structure de type double semi-conducteur sur isolant comprenant successivement depuis une face arrière vers une face avant de la structure : un substrat support, une première couche électriquement isolante, une première couche semi-conductrice monocristalline, une seconde couche électriquement isolante et une seconde couche semi-conductrice monocristalline, le procédé étant caractérisé en ce qu'il comprend :
- une première étape de formation d'une couche d'oxyde sur les faces avant et arrière du substrat support pour former la première couche électriquement isolante sur la face avant du substrat support et une couche d'oxyde sur la face arrière du substrat support,
- une première étape de transfert de couche pour transférer la première couche semi-conductrice monocristalline d'un premier substrat donneur sur la première couche électriquement isolante, de sorte à former un premier substrat de type semi-conducteur sur isolant comprenant successivement de la face arrière vers la face avant dudit premier substrat semi-conducteur sur isolant ; la couche d'oxyde, le substrat support, la première couche électriquement isolante et la première couche semi-conductrice monocristalline,
- une seconde étape de formation d'une couche d'oxyde sur la face avant du premier substrat de type semi-conducteur sur isolant pour former la deuxième couche électriquement isolante et épaissir la couche d'oxyde,
- une seconde étape de transfert de couche pour transférer la seconde couche semi-conductrice monocristalline d'un second substrat donneur sur la deuxième couche électriquement isolante, de sorte à former le substrat de type double semi-conducteur sur isolant,
la couche d'oxyde contribuant à la préservation de la planéité du substrat support pendant la première et la seconde étape de transfert.

Les différentes couches de la structure de type double SOI ayant des coefficients de dilatation thermiques différents, une telle structure peut être sujette à des déformations. De telles déformations surviennent notamment à l'issue des différents traitements thermiques qui peuvent être appliqués à la structure, lors du refroidissement de ladite structure. La formation d'une couche d'oxyde sur la face arrière de la structure de type double SOI conforme à l'invention permet avantageusement d'atteindre un équilibre structurel de sorte que les effets de dilatation thermique se compensent sur l'ensemble de la structure limitant ainsi fortement sa déformation.

Selon d'autres caractéristiques optionnelles de l'invention prises seules ou en combinaison lorsque cela est techniquement possible :
- l'épaisseur de la première couche électriquement isolante est comprise entre 100 nm et 3000 nm,
- dans la structure finale de type double semi-conducteur sur isolant obtenue, l'épaisseur de la première couche semi-conductrice monocristalline est comprise entre 50 nm et 500 nm,
- dans la structure finale de type double semi-conducteur sur isolant obtenue, l'épaisseur de la deuxième couche électriquement isolante est comprise entre 100 nm et 1100 nm,
- dans la structure finale de type double semi-conducteur sur isolant obtenue, l'épaisseur de la deuxième couche semi-conductrice monocristalline est comprise entre 50 nm et 500nm,
- l'étape de transfert de la première couche semi-conductrice monocristalline d'un premier substrat donneur sur la première couche électriquement isolante est mise en œuvre selon un procédé comprenant successivement l'implantation d'espèces atomiques afin de créer une zone de fragilisation au sein du premier substrat donneur délimitant la première couche semi-conductrice monocristalline, le collage de la face du premier substrat donneur de la première couche semi-conductrice monocristalline ayant subi l'implantation sur la première couche électriquement isolante et la fracture du premier substrat donneur au niveau de la zone de fragilisation,
- on utilise le reliquat du premier substrat donneur résultant de la fracture pour former le second substrat donneur,
- le procédé de transfert de la première couche semi-conductrice monocristalline d'un premier substrat donneur sur la première couche électriquement isolante comprend en outre l'oxydation de la surface du premier substrat donneur préalablement à l'implantation d'espèces atomiques au sein dudit premier substrat donneur, formant ainsi une première couche d'oxyde protectrice de sorte que les espèces atomiques sont implantées à travers ladite première couche d'oxyde protectrice,
- la première couche d'oxyde protectrice formée à la surface du premier substrat donneur est retirée après l'implantation des espèces atomiques et préalablement au collage du premier substrat donneur sur la première couche électriquement isolante,
- l'étape de transfert de la deuxième couche semi-conductrice monocristalline d'un second substrat donneur sur la deuxième couche électriquement isolante est mise en oeuvre selon un procédé comprenant successivement l'implantation d'espèces atomiques afin de créer une zone de fragilisation au sein du second substrat donneur délimitant la deuxième couche semi-conductrice monocristalline, le collage de la face dudit second substrat donneur de la deuxième couche semi-conductrice monocristalline ayant subi l'implantation sur la deuxième couche électriquement isolante et la fracture du second substrat donneur au niveau de la zone de fragilisation,
- le procédé de transfert de la deuxième couche semi-conductrice monocristalline d'un second substrat donneur sur la deuxième couche électriquement isolante comprend en outre l'oxydation de la surface du second substrat donneur préalablement à l'implantation d'espèces atomiques au sein dudit second substrat donneur, formant ainsi une seconde couche d'oxyde protectrice de sorte que les espèces atomiques sont implantées à travers ladite seconde couche d'oxyde protectrice.
- la seconde couche d'oxyde protectrice formée à la surface du second substrat donneur est retirée après l'implantation des espèces atomiques et préalablement au collage du second substrat donneur sur la deuxième couche électriquement isolante,
- le procédé comprend en outre une étape de mise en oeuvre d'un procédé de traitement de la surface du premier substrat de type semi-conducteur sur isolant simple préalablement à la seconde étape de formation d'une couche d'oxyde sur la surface de ce premier substrat de type semi-conducteur sur isolant simple, le procédé de traitement de la surface étant caractérisé par :
   - une première étape de recuit thermique rapide,
   - une deuxième étape d'oxydation thermique suivie d'une désoxydation,
   - une troisième étape de traitement thermique de longue durée ou une troisième étape de recuit thermique rapide, le traitement thermique de longue durée et le recuit thermique rapide étant mené à une température supérieure à 1000 °C dans une atmosphère non oxydante,
   - une quatrième étape de polissage mécano-chimique.
- le substrat support et chaque substrat donneur se présentent sous la forme d'une plaque de 300 mm de diamètre.

### BREVE DESCRIPTION DES FIGURES

D'autres caractéristiques et avantages de l'invention ressortiront de la description détaillée qui va suivre, en référence aux dessins annexés, sur lesquels :
- la figure 1 représente une vue en coupe d'un substrat support ;
- la figure 2 représente une vue en coupe du substrat support après une première étape d'oxydation des faces avant et arrière du substrat support ;
- la figure 3 représente une vue en coupe d'un premier transfert de couche par un premier substrat donneur sur la face avant du substrat support ;
- la figure 4 représente une vue en coupe de la structure intermédiaire obtenue après collage du premier substrat donneur ;
- la figure 5 représente une vue en coupe de la structure intermédiaire de type semi-conducteur sur isolant obtenue suite au premier transfert de couche ;
- la figure 6 représente une vue en coupe de la structure intermédiaire obtenue après une deuxième étape d'oxydation sur les faces avant et arrière du substrat de type semi-conducteur sur isolant de la figure 5 ;
- la figure 7 représente une vue en coupe d'un deuxième transfert de couche par un deuxième substrat donneur sur la face avant de la structure intermédiaire de la figure 6 ;
- la figure 8 représente une vue en coupe de la structure obtenue après collage du deuxième substrat donneur ;
- la figure 9 représente la structure finale de type double semi-conducteur sur isolant obtenue suite au deuxième transfert de couche.

Pour des raisons de lisibilité, les dessins ne sont pas nécessairement réalisés à l'échelle.

### DESCRIPTION DETAILLEE DE MODES DE REALISATION

L'invention propose un procédé de fabrication d'une structure de type double substrat semi-conducteur sur isolant comportant, de la face arrière vers la face avant, un substrat support, une première couche d'oxyde enterrée correspondant à une première couche électriquement isolante, une première couche semi-conductrice monocristalline, une deuxième couche d'oxyde enterrée correspondant à une deuxième couche électriquement isolante et une deuxième couche semi-conductrice monocristalline.

La première couche électriquement isolante et la première couche semi-conductrice monocristalline forment ensemble une première structure de type semi-conducteur sur isolant appelée structure SOI inférieure. La deuxième couche électriquement isolante et la deuxième couche semi-conductrice monocristalline forment ensemble une deuxième structure de type semi-conducteur sur isolant appelée structure SOI supérieure. En outre, le substrat support comporte avantageusement, sur sa face arrière, une couche d'oxyde permettant de limiter la déformation du support lors de la mise en oeuvre du procédé qui fait l'objet de l'invention.

La somme des épaisseurs des couches qui constituent la structure de type double substrat semi-conducteur sur isolant obtenue par le procédé qui fait l'objet de l'invention est élevée. En particulier :
- l'épaisseur de la première couche électriquement isolante est de préférence supérieure à 100 nm,
- l'épaisseur de la première couche semi-conductrice monocristalline est de préférence supérieure à 50 nm et inférieure à 500 nm,
- l'épaisseur de la deuxième couche électriquement isolante est de préférence supérieure à 100nm et inférieure à 1100nm,
- l'épaisseur de la deuxième couche semi-conductrice monocristalline est de préférence supérieure à 50 nm et inférieure 500 nm ,

Dans le cadre d'une application en photonique par exemple, de telles épaisseurs de couches permettent de réaliser des composants photoniques passifs (tel qu'un guide d'onde) ou actifs (tels qu'un résonnateur).

De telles épaisseurs ne sont pas atteignables par le procédé Smart Cut^{™} classique, dans lequel la couche semi-conductrice monocristalline est délimitée par implantation d'espèces atomiques dans un substrat donneur recouvert d'une couche d'oxyde destinée à former la couche électriquement isolante dans la structure SOI. En effet, les dispositifs d'implantation industriels ont une énergie maximale ne permettant pas aux atomes d'hydrogène et/ou d'hélium de traverser une épaisseur aussi importante de la couche d'oxyde et de la couche semi-conductrice monocristalline.

### Première étape d'oxydation

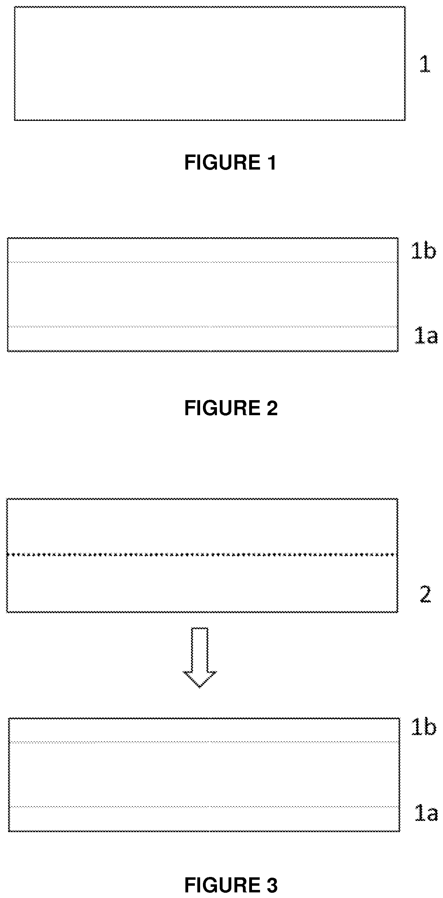

En référence à la **figure 1****,** on fournit initialement un substrat support 1. Le substrat support 1 se présente sous la forme d'une plaque d'un matériau semi-conducteur, préférentiellement une plaque de 300 mm de diamètre et de 775 µm d'épaisseur. Le substrat support 1 est par exemple une plaque de silicium, préférentiellement une plaque de silicium ayant une haute résistivité avec un fort taux d'oxygène interstitiel Oi communément appelée « substrat HR » ou substrat « high Oi » selon la terminologie anglo-saxonne.

Dans une première étape représentée sur la **figure 2****,** on oxyde les faces avant et arrière du substrat 1, ainsi que les bords dudit substrat 1.

Lors de l'oxydation du côté de la face avant, le substrat support 1 est partiellement consommé pour former la première couche d'oxyde électriquement isolante 1b. À titre d'exemple, si le substrat support est un substrat de silicium, la première couche d'oxyde électriquement isolante 1b est donc une couche d'oxyde de silicium. Les conditions d'oxydation sont contrôlées pour obtenir la première couche d'oxyde électriquement isolante 1b ayant l'épaisseur souhaitée.

Une telle opération d'oxydation peut par exemple être menée en chauffant le substrat support 1 à une température comprise entre 800°C et 1100°C sous atmosphère oxydante pendant quelques minutes à plusieurs heures pour obtenir une épaisseur élevée de la première couche d'oxyde électriquement isolante 1b comprise entre 100nm et 3000 nm.

L'oxydation simultanée de la face arrière conduit avantageusement à la formation d'une couche d'oxyde 1a sur la face arrière du support, qui présente sensiblement la même épaisseur que la couche d'oxyde 1b formée sur la face avant. La couche d'oxyde 1a présente un coefficient de dilatation thermique inférieur à celui du substrat support 1 non oxydé. Dans la suite du procédé, en particulier à l'issue de la mise en oeuvre de traitements thermiques, la présence de la couche d'oxyde 1a sur la face arrière du substrat support 1 permet de limiter la déformation dudit substrat support 1 et améliore ainsi la qualité du collage ultérieur des nouvelles couches sur la face avant de la structure.

L'épaisseur de la couche d'oxyde 1a obtenue dans les conditions d'oxydation décrites ci-dessus est identique à l'épaisseur de la première couche électriquement isolante 1b. Au cours des éventuels traitements thermiques ultérieurs et des périodes de refroidissement qui suivent lesdits traitements, une telle épaisseur de la couche d'oxyde 1a permet d'équilibrer les effets de dilatation thermique subis par l'ensemble de la structure et donc d'éviter la déformation de ladite structure.

### Première étape de transfert de couche

En référence à la **figure 3****,** on fournit un premier substrat donneur d'une première couche semi-conductrice monocristalline 2. Le premier substrat donneur est un substrat semi-conducteur monocristallin, par exemple un substrat de silicium monocristallin. Le premier substrat donneur se présente sous la forme d'une plaque de même diamètre que le substrat support 1 et d'épaisseur entre 670 µm et 775 µm.

Selon un mode de réalisation, un premier transfert de couche est mis en oeuvre selon le procédé Smart Cut^{™}. On forme dans le premier substrat donneur une zone de fragilisation (traits pointillés sur la **figure 3****),** de manière à délimiter la première couche semi-conductrice 2. La zone de fragilisation est formée dans le substrat donneur à une profondeur prédéterminée qui correspond sensiblement à l'épaisseur de la couche semi-conductrice 2 à transférer. De préférence, la zone de fragilisation est créée par implantation d'ions d'hydrogène et/ou d'hélium dans le substrat donneur de couche semi-conductrice.

Puisque la première couche électriquement isolante 1b a été formée à partir du substrat receveur constitué par le substrat support 1, et non à partir du premier substrat donneur, l'épaisseur de la première couche semi-conductrice 2 transférée n'est limitée que par l'énergie maximale du dispositif d'implantation qui est de l'ordre de 100 keV. Une telle énergie maximale d'implantation correspond à une épaisseur maximale de la première couche semi-conductrice 2 transférée de l'ordre de 600nm selon les espèces implantées. L'invention permet donc de transférer une première couche semi-conductrice 2 d'épaisseur élevée tout en ayant une première couche électriquement isolante 1b ayant également une épaisseur élevée.

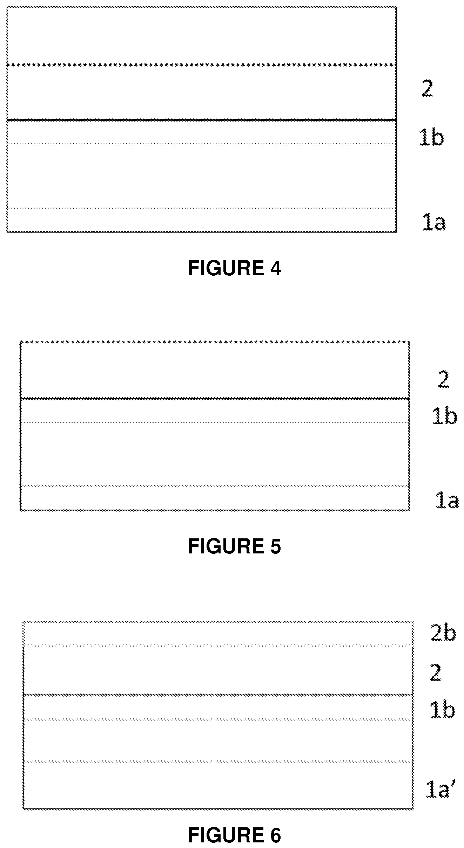

En référence à la **figure 4****,** on transfère ensuite la première couche semi-conductrice 2 en collant la face du premier substrat donneur ayant subi l'implantation sur la première couche d'oxyde électriquement isolante 1b et en détachant le reliquat du substrat donneur le long de la zone de fragilisation (voir **figure 5****).** Le détachement le long de la zone de fragilisation peut être déclenché par une action mécanique et/ou un apport d'énergie thermique. Au cours de la première étape de transfert de couche, au moins une partie de la couche d'oxyde sur la face arrière du substrat support est conservée, de sorte à limiter les problèmes liés à la déformation de la plaque.

Préalablement à l'implantation d'espèces atomiques au sein dudit premier substrat donneur, on peut optionnellement oxyder la surface du premier substrat donneur sur une très faible épaisseur, par exemple sur une épaisseur comprise entre 20 et 30 nm. En effet, l'implantation des espèces atomiques au sein du premier substrat donneur est meilleure si elle est faite à travers ladite très fine couche d'oxyde, qui est une phase amorphe, plutôt que directement au sein du matériau monocristallin. En outre, la très fine couche d'oxyde constitue une protection de la première couche semi-conductrice 2 lors de l'implantation atomique. Dans ce cas, la très fine couche d'oxyde à la surface du premier substrat donneur est retirée après l'implantation des espèces atomiques et avant le collage du premier substrat donneur sur la première couche électriquement isolante 1b.

L'oxydation de la surface du premier substrat donneur sur une très faible épaisseur peut être réalisée à une température comprise entre 800°C et 1000. °C pendant quelques minutes à quelques dizaines de minutes sous atmosphère oxydante.

De manière alternative au procédé Smart Cut^{™} décrit ci-dessus, le premier transfert de couche peut être réalisé en amincissant le substrat donneur par sa face opposée à la face collée sur le substrat support, jusqu'à l'obtention de l'épaisseur souhaitée pour la première couche semi-conductrice.

Suite au premier transfert de couche, en référence à la **figure 5****,** on obtient un premier substrat de type semi-conducteur sur isolant comprenant la première couche électriquement isolante 1b et la première couche semi-conductrice monocristalline 2. Ledit substrat de type semi-conducteur sur isolant, présente une rugosité de surface qui dépend du procédé utilisé par le transfert de couche. Afin de permettre une bonne qualité de collage et limiter la formation de trous lors du collage du second substrat donneur de couche décrit ci-après, on peut appliquer différents traitements de la surface libre de la première couche semi-conductrice monocristalline 2 pour diminuer la rugosité et la défectivité de ladite surface, par exemple un traitement thermique de lissage, une oxydation sacrificielle et/ou un nettoyage. Ce traitement de surface permet d'améliorer la qualité du collage ultérieur avec le second substrat donneur lors de la deuxième étape de transfert de couche.

A l'issue des traitements thermiques et lorsque la structure revient à l'équilibre thermique (par exemple la température ambiante), l'existence de la couche d'oxyde 1a (ayant une épaisseur prédéfinie) permet de préserver un équilibre structurel, la planéité du substrat et de ce fait la qualité du collage du second substrat donneur.

### Deuxième étape d'oxydation

On oxyde ensuite les faces avant et arrière du premier substrat de type semi-conducteur sur isolant, comme visible sur la **figure 6****.**

L'oxydation sur la face avant conduit à une consommation partielle de la première couche semi-conductrice monocristalline 2, donc à une diminution de l'épaisseur de ladite couche semi-conductrice monocristalline 2 préalablement transférée, et à la formation de la deuxième couche électriquement isolante 2b. A titre d'exemple, si le premier substrat donneur est un substrat de silicium, la deuxième couche d'oxyde électriquement isolante 2b est donc une couche d'oxyde de silicium.

L'oxydation sur la face arrière conduit à une augmentation de l'épaisseur de la couche initiale d'oxyde 1a.

La deuxième étape d'oxydation peut par exemple être menée en effectuant un recuit de la structure de type semi-conducteur sur isolant obtenue suite au premier transfert de couche à une température comprise entre 800°C et 1100°C sous atmosphère oxydante pendant quelques minutes à quelques heures pour obtenir une épaisseur de la deuxième couche d'oxyde électriquement isolante 2b comprise entre 100 nm et 1100 nm.

L'épaisseur de la première couche semi-conductrice 2 dans la structure finale est essentiellement l'épaisseur de la première couche semi-conductrice 2 transférée moins l'épaisseur de la couche semi-conductrice 2 consommée pour former la deuxième couche électriquement isolante 2b. L'épaisseur maximale de la première couche semi-conductrice 2 au moment du transfert est limitée seulement par le procédé d'implantation, elle est généralement inférieure à 2µm, et préférentiellement d'environ 600 nm. L'épaisseur de la première couche semi-conductrice 2 dans la structure finale peut donc être préférentiellement comprise entre 50 nm et 1 µm, et encore plus préférentiellement entre 50 et 500 nm.

A titre d'exemple, si l'épaisseur de la première couche semi-conductrice 2 transférée est de 600 nm, les traitements de surface pour améliorer la qualité de surface de ladite première couche semi-conductrice 2 consomment le matériau semi-conducteur sur environ 100 nm d'épaisseur. La deuxième étape d'oxydation peut alors consommer une épaisseur de 450 nm de matériau semi-conducteur pour laisser une première couche semi-conductrice 2 d'une épaisseur de 50 nm et former une deuxième couche électriquement isolante 2b de l'ordre de 1000 nm d'épaisseur.

Préalablement au deuxième transfert de couche, on peut avantageusement mettre en oeuvre un nettoyage et/ou un polissage mécano-chimique de la surface libre de la deuxième couche électriquement isolante 2b.

### Deuxième étape de transfert de couche

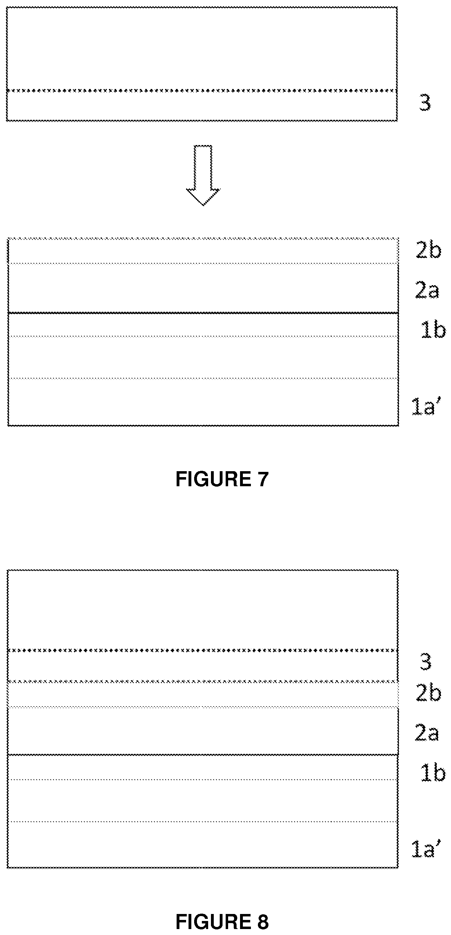

Par ailleurs, en référence à la **figure 7****,** on fournit un second substrat donneur d'une deuxième couche semi-conductrice monocristalline 3. Tout comme le premier substrat donneur, le second substrat donneur est un substrat semi-conducteur monocristallin, par exemple un substrat de silicium monocristallin. Le second substrat donneur se présente sous la forme d'une plaque de même diamètre que le substrat support 1 et le premier substrat donneur. Eventuellement, on peut recycler le reliquat du premier substrat donneur pour former le second substrat donneur. A cet effet, on traite le reliquat du premier substrat donneur pour retirer les défauts liés à l'implantation et au détachement, et pour lui donner un état de surface compatible avec un nouveau collage.

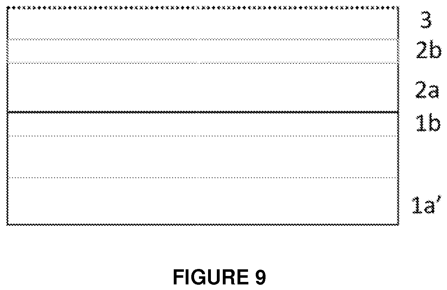

Selon un mode de réalisation, on fait le second transfert de couche selon le procédé Smart Cut^{™}. On forme dans ce deuxième substrat donneur une zone de fragilisation délimitant la deuxième couche semi-conductrice monocristalline 3 (voir traits pointillés sur la **figure 7****).** La zone de fragilisation peut être formée de la même manière que pour délimiter la première couche semi-conductrice monocristalline 2 au sein du premier substrat donneur. En référence à la **figure 8****,** on transfère ensuite la deuxième couche semi-conductrice monocristalline 3 en collant la face du second substrat donneur ayant subi l'implantation sur la deuxième couche électriquement isolante 2b. En référence à la **figure 9****,** on élimine le reliquat du second substrat donneur en le fracturant le long de la zone de fragilisation.

Préalablement à la formation de la zone de fragilisation au sein dudit second substrat donneur, on peut optionnellement oxyder la surface du second substrat donneur sur une très faible épaisseur, par exemple sur une épaisseur comprise entre 20 et 30 nm. La très fine couche d'oxyde à la surface du second substrat donneur est préférentiellement retirée après la formation de la zone de fragilisation et avant le collage du second substrat donneur sur la deuxième couche électriquement isolante 2b.

Tout comme pour le premier substrat donneur, l'oxydation de la surface du second substrat donneur sur une très faible épaisseur peut être réalisée à une température comprise entre 800 °C et 1000 °C pendant quelques minutes à quelques dizaines de minutes sous atmosphère oxydante.

De manière alternative, le second transfert de couche peut être réalisé en amincissant le second substrat donneur par sa face opposée à la face collée sur la deuxième couche électriquement isolante 2b jusqu'à l'obtention de l'épaisseur souhaitée pour la deuxième couche semi-conductrice 3.

Au cours de la deuxième étape de transfert de couche, au moins une partie de la couche d'oxyde sur la face arrière du substrat support est conservée, de sorte à limiter les problèmes liés à la déformation de la plaque.

Suite au second transfert de couche, on obtient une deuxième structure de type semi-conducteur sur isolant, comprenant la deuxième couche électriquement isolante 2b et la deuxième couche semi-conductrice monocristalline 3, qui constitue la structure supérieure de type semi-conducteur sur isolant de la structure finale de type double semi-conducteur sur isolant (voir **figure 9****).**

Puisque la deuxième couche électriquement isolante 2b a été formée à partir d'un deuxième substrat receveur constitué par le premier substrat de type semi-conducteur sur isolant oxydé sur sa face avant, et non à partir du second substrat donneur, l'épaisseur de la deuxième couche semi-conductrice 3 transférée n'est limitée que par l'énergie maximale du procédé d'implantation. Une telle énergie maximale d'implantation correspond à une épaisseur de la deuxième couche semi-conductrice 3 de l'ordre de 600nm selon les espèces implantées . L'invention permet donc également d'obtenir une deuxième couche semi-conductrice 3 d'épaisseur élevée tout en ayant une deuxième couche électriquement isolante 2b ayant également une épaisseur élevée.

Optionnellement, on peut mettre en oeuvre différents traitements de la surface libre de la deuxième couche semi-conductrice 3, par exemple pour parfaire l'épaisseur de ladite couche ou pour améliorer la qualité de ladite surface libre en vue d'éventuelles fonctionnalisations ultérieures. Dans le cas de traitements thermiques, la couche d'oxyde 1a sur la face arrière du substrat support 1 limite avantageusement la déformation de la structure de type double semi-conducteur sur isolant.

### Traitements de surface optionnels

De manière optionnelle, on peut procéder à un traitement de la surface libre de la première couche semi-conductrice 2 avant l'étape d'oxydation conduisant à la formation de la deuxième couche électriquement isolante 2b afin d'en réduire la rugosité et la défectivité. La diminution de la rugosité et de la défectivité de la surface de la première couche semi-conductrice 2 permet de générer une deuxième couche électriquement isolante 2b dont la surface présente également des caractéristiques compatibles avec un collage ultérieur de bonne qualité, notamment une faible rugosité et une faible défectivité. Alternativement ou additionnellement, on peut procéder à un traitement de la surface libre de la deuxième couche électriquement isolante 2b avant le second transfert de couche, par exemple un polissage mécano-chimique et/ou un nettoyage. Ces traitements de surface améliorent le collage de la deuxième couche semi-conductrice monocristalline 3 en limitant notamment la formation de trou et d'autres défauts.

Le traitement de la surface libre de la première couche semi-conductrice 2 avant la deuxième étape d'oxydation, et/ou de la deuxième couche électriquement isolante 2b avant la deuxième étape de transfert de couche, peut lui-même impliquer la mise en oeuvre d'un procédé en plusieurs étapes. Un exemple de procédé utilisé préférentiellement pour le traitement de la surface libre de la première couche semi-conductrice monocristalline 2 (avant la formation de la couche d'oxyde 2b) comprend les étapes successives suivantes :
- (E1) un recuit thermique rapide,
- (E2) une séquence d'oxydation / désoxydation,
- (E3) un recuit thermique de longue durée, connu par l'homme du métier sous sa dénomination anglaise « batch anneal »,
- (E4) un polissage mécano-chimique.
Alternativement, l'étape (E3) de recuit thermique de longue durée est remplacée par une étape (E3') de recuit thermique rapide. Alternativement encore, les étapes (E1), (E2) et (E3/E3') dudit procédé sont mises en oeuvre sur la surface libre de la première couche semi-conductrice monocristalline 2 et l'étape (E4) peut être mise en oeuvre avant et après la deuxième étape d'oxydation (pour former la couche d'oxyde 2b), respectivement sur la surface de la première couche semi-conductrice monocristalline 2 et sur la surface de la deuxième couche électriquement isolante 2b.

Par « recuit thermique rapide », on entend un recuit pendant une durée de quelques secondes ou quelques dizaines de secondes, sous atmosphère contrôlée. Un tel recuit est communément désigné par l'appellation de recuit RTA pour « Rapid Thermal Annealing » en anglais. Le recuit thermique rapide (E1) est réalisé à une température comprise entre 1100°C et 1250°C pendant quelques secondes à une centaine de secondes. Le recuit thermique rapide (E1) est réalisé sous une atmosphère comprenant un mélange d'hydrogène et / ou d'argon.

L'étape (E2) d'oxydation / désoxydation doit être comprise comme une séquence comprenant la succession des opérations suivantes :
- une opération d'oxydation thermique (E2a),
- une opération de désoxydation (E2b).
L'opération d'oxydation (E2a) peut par exemple être menée en chauffant la structure à une température comprise entre 800°C et 1100°C pendant quelques minutes à quelques heures sous atmosphère oxydante. L'opération de désoxydation (E2b) peut par exemple être menée en exposant la face avant de la structure à une solution d'acide fluorhydrique (HF) pendant quelques secondes à quelques minutes pour retirer la couche d'oxyde formée sur la face avant, sans retirer la couche d'oxyde présente sur la face arrière de la structure. Cette étape d'oxydation / désoxydation permet d'ajuster l'épaisseur de la couche semi-conductrice en consommant une portion superficielle du silicium par l'oxydation.

Le recuit thermique de longue durée, dit « batch anneal » en anglais, correspond à un recuit thermique d'une durée de l'ordre de de quelques minutes à quelques heures, généralement supérieure à 15 min, avantageusement réalisé dans un four à atmosphère contrôlée. Le recuit en four (E3) est réalisé à une température comprise entre 1050°C et 1250°C. En outre, le recuit en four (E3) est par exemple mené sous atmosphère inerte, par exemple sous argon.

Au cours du polissage mécano-chimique, ou CMP selon l'acronyme de l'expression anglaise « Chemical-Mechanical Polishing », on modifie la surface à polir à l'aide d'un agent chimique, par exemple une suspension de particules de silice colloïdale dans une base liquide, et on enlève par abrasion mécanique la surface modifiée. La vitesse de rotation et la pression utilisées lors de l'étape (E4) de CMP sont optimisées de sorte à retirer de manière uniforme de la matière en surface de la première couche semi-conductrice 2 ou de la deuxième couche électriquement isolante 2b, sans pour autant dégrader l'état de ladite surface, notamment sans en augmenter la rugosité.

Alternativement, le recuit thermique rapide (E3') est réalisé à une température comprise entre 1100°C et 1250°C pendant quelques secondes à une centaine de secondes, par exemple sous une atmosphère comprenant un mélange d'hydrogène et/ou argon.

De manière optionnelle, on peut également procéder à un traitement de la surface libre de la deuxième couche semi-conductrice 3 ou une fonctionnalisation en fonction de l'application visée.

Lors de ces différentes étapes de traitement de surface, en particulier lors des étapes de traitement thermique, la couche d'oxyde 1a limite très avantageusement la déformation de la plaque.

## Revendications

1. Procédé de fabrication d'une structure de type double semi-conducteur sur isolant comprenant successivement depuis une face arrière vers une face avant de la structure : un substrat support (1), une première couche électriquement isolante (1b), une première couche semi-conductrice monocristalline (2), une seconde couche électriquement isolante (2b) et une seconde couche semi-conductrice monocristalline (3), le procédé étant **caractérisé en ce qu'**il comprend :
- une première étape de formation d'une couche d'oxyde sur les faces avant et arrière du substrat support (1) pour former la première couche électriquement isolante (1b) sur la face avant du substrat support et une couche d'oxyde (1a) sur la face arrière du substrat support,
- une première étape de transfert de couche pour transférer la première couche semi-conductrice monocristalline (2) d'un premier substrat donneur sur la première couche électriquement isolante (1b), de sorte à former un premier substrat de type semi-conducteur sur isolant, comprenant successivement de la face arrière vers la face avant dudit premier substrat semi-conducteur sur isolant ; la couche d'oxyde (1a), le substrat support (1), la première couche électriquement isolante (1b) et la première couche semi-conductrice monocristalline (2),
- une seconde étape de formation d'une couche d'oxyde sur la face avant du premier substrat de type semi-conducteur sur isolant pour former la deuxième couche électriquement isolante (2b) et épaissir la couche d'oxyde (1a) sur la face arrière du substrat support,
- une seconde étape de transfert de couche pour transférer la seconde couche semi-conductrice monocristalline (3) d'un second substrat donneur sur la deuxième couche électriquement isolante (2b), de sorte à former le substrat de type double semi-conducteur sur isolant,
la couche d'oxyde (1a) sur la face arrière du substrat support contribuant à la préservation de la planéité du substrat support pendant la première et la seconde étape de transfert.

2. Procédé selon la revendication 1 dans lequel l'épaisseur de la première couche électriquement isolante (1b) est comprise entre 100 nm et 3000 nm.

3. Procédé selon l'une quelconque des revendications 1 ou 2 tel que dans la structure finale de type double semi-conducteur sur isolant obtenue, l'épaisseur de la première couche semi-conductrice monocristalline (2) est comprise entre 50 nm et 500 nm.

4. Procédé selon l'une quelconque des revendications 1 à 3 tel que dans la structure finale de type double semi-conducteur sur isolant obtenue, l'épaisseur de la deuxième couche électriquement isolante (2b) est comprise entre 100 nm et 1100 nm.

5. Procédé selon l'une quelconque des revendications 1 à 4 tel que, dans la structure finale de type double semi-conducteur sur isolant obtenue, l'épaisseur de la deuxième couche semi-conductrice monocristalline (3) est comprise entre 50 nm et 500nm.

6. Procédé selon l'une quelconque des revendications 1 à 5 dans lequel l'étape de transfert de la première couche semi-conductrice monocristalline (2) d'un premier substrat donneur sur la première couche électriquement isolante (1b) est mise en œuvre selon un procédé comprenant successivement l'implantation d'espèces atomiques afin de créer une zone de fragilisation au sein du premier substrat donneur délimitant la première couche semi-conductrice monocristalline (2), le collage de la face du premier substrat donneur de la première couche semi-conductrice monocristalline (2) ayant subi l'implantation sur la première couche électriquement isolante (1b) et la fracture du premier substrat donneur au niveau de la zone de fragilisation.

7. Procédé selon la revendication 6 dans lequel on utilise le reliquat du premier substrat donneur résultant de la fracture pour former le second substrat donneur.

8. Procédé selon l'une quelconque des revendications 6 ou 7 dans lequel le procédé de transfert de la première couche semi-conductrice monocristalline (2) d'un premier substrat donneur sur la première couche électriquement isolante (1b) comprend en outre l'oxydation de la surface du premier substrat donneur préalablement à l'implantation d'espèces atomiques au sein dudit premier substrat donneur, formant ainsi une première couche d'oxyde protectrice de sorte que les espèces atomiques sont implantées à travers ladite première couche d'oxyde protectrice.

9. Procédé selon la revendication 8 dans lequel la première couche d'oxyde protectrice formée à la surface du premier substrat donneur est retirée après l'implantation des espèces atomiques et préalablement au collage du premier substrat donneur sur la première couche électriquement isolante (1b).

10. Procédé selon l'une quelconque des revendications 1 à 9 dans lequel l'étape de transfert de la deuxième couche semi-conductrice monocristalline (3) d'un second substrat donneur sur la deuxième couche électriquement isolante (2b) est mise en œuvre selon un procédé comprenant successivement l'implantation d'espèces atomiques afin de créer une zone de fragilisation au sein du second substrat donneur délimitant la deuxième couche semi-conductrice monocristalline (3), le collage de la face dudit second substrat donneur de la deuxième couche semi-conductrice monocristalline (3) ayant subi l'implantation sur la deuxième couche électriquement isolante (2b) et la fracture du second substrat donneur au niveau de la zone de fragilisation.

11. Procédé selon la revendication 10 dans lequel le procédé de transfert de la deuxième couche semi-conductrice monocristalline (3) d'un second substrat donneur sur la deuxième couche électriquement isolante (2b) comprend en outre l'oxydation de la surface du second substrat donneur préalablement à l'implantation d'espèces atomiques au sein dudit second substrat donneur, formant ainsi une seconde couche d'oxyde protectrice de sorte que les espèces atomiques sont implantées à travers ladite seconde couche d'oxyde protectrice.

12. Procédé selon la revendication 11, dans lequel la seconde couche d'oxyde protectrice formée à la surface du second substrat donneur est retirée après l'implantation des espèces atomiques et préalablement au collage du second substrat donneur sur la deuxième couche électriquement isolante (2b).

13. Procédé selon l'une quelconque des revendications 1 à 12, comprenant en outre une étape de mise en œuvre d'un procédé de traitement de la surface du premier substrat de type semi-conducteur sur isolant simple préalablement à la seconde étape de formation d'une couche d'oxyde sur la surface de ce premier substrat de type semi-conducteur sur isolant simple, le procédé de traitement de la surface étant **caractérisé par** :
- une première étape de recuit thermique rapide,
- une deuxième étape d'oxydation thermique suivie d'une désoxydation,
- une troisième étape de traitement thermique de longue durée ou une troisième étape de recuit thermique rapide, le traitement thermique de longue durée et le recuit thermique rapide étant mené à une température supérieure à 1000 °C dans une atmosphère non oxydante,
- une quatrième étape de polissage mécano-chimique.

14. Procédé selon l'une des revendications 1 à 13, dans lequel le substrat support et chaque substrat donneur se présentent sous la forme d'une plaque de 300 mm de diamètre.

## Patentansprüche

1. Verfahren zur Herstellung einer Struktur vom Typ doppelter Halbleiter-auf-Isolator, die von einer Rückseite zu einer Vorderseite der Struktur nacheinander umfasst: ein Trägersubstrat (1), eine erste elektrisch isolierende Schicht (1b), eine erste monokristalline halbleitende Schicht (2), eine zweite elektrisch isolierende Schicht (2b) und eine zweite monokristalline halbleitende Schicht (3), wobei das Verfahren **dadurch gekennzeichnet ist, dass** es umfasst:
- einen ersten Schritt des Bildens einer Oxidschicht auf der Vorder- und Rückseite des Trägersubstrats (1), um die erste elektrisch isolierende Schicht (1b) auf der Vorderseite des Trägersubstrats und eine Oxidschicht (1a) auf der Rückseite des Trägersubstrats zu bilden,
- einen ersten Schichtübertragungsschritt, um die erste monokristalline halbleitende Schicht (2) von einem ersten Donorsubstrat auf die erste elektrisch isolierende Schicht (1b) derart zu übertragen, dass ein erstes Substrat vom Typ Halbleiter-auf-Isolator gebildet wird, das nacheinander von der Rückseite zur Vorderseite des ersten Halbleiter-auf-Isolator-Substrats umfasst: die Oxidschicht (1a), das Trägersubstrat (1), die erste elektrisch isolierende Schicht (1b) und die erste monokristalline halbleitende Schicht (2),
- einen zweiten Schritt des Bildens einer Oxidschicht auf der Vorderseite des ersten Substrats vom Typ Halbleiter-auf-Isolator, um die zweite elektrisch isolierende Schicht (2b) zu bilden und die Oxidschicht (1a) auf der Rückseite des Trägersubstrats zu verdicken,
- einen zweiten Schichtübertragungsschritt, um die zweite monokristalline halbleitende Schicht (3) von einem zweiten Donorsubstrat auf die zweite elektrisch isolierende Schicht (2b) derart zu übertragen, dass das Substrat vom Typ doppelter Halbleiter-auf-Isolator gebildet wird,
wobei die Oxidschicht (1a) auf der Rückseite des Trägersubstrat zum Schutz der Ebenheit des Trägersubstrats während des ersten und des zweiten Übertragungsschritts beiträgt.

2. Verfahren nach Anspruch 1, wobei die Dicke der ersten elektrisch isolierenden Schicht (1b) zwischen 100 nm und 3000 nm liegt.

3. Verfahren nach einem der Ansprüche 1 oder 2, wobei in der erhaltenen endgültigen Struktur vom Typ doppelter Halbleiter-auf-Isolator die Dicke der ersten monokristallinen halbleitenden Schicht (2) zwischen 50 nm und 500 nm liegt.

4. Verfahren nach einem der Ansprüche 1 bis 3, wobei in der erhaltenen endgültigen Struktur vom Typ doppelter Halbleiter-auf-Isolator die Dicke der zweiten elektrisch isolierenden Schicht (2b) zwischen 100 nm und 1100 nm liegt.

5. Verfahren nach einem der Ansprüche 1 bis 4, wobei in der erhaltenen endgültigen Struktur vom Typ doppelter Halbleiter-auf-Isolator die Dicke der zweiten monokristallinen halbleitenden Schicht (3) zwischen 50 nm und 500 nm liegt.

6. Verfahren nach einem der Ansprüche 1 bis 5, wobei der Schritt des Übertragens der ersten monokristallinen halbleitenden Schicht (2) von einem ersten Donorsubstrat auf die erste elektrisch isolierende Schicht (1b) nach einem Verfahren durchgeführt wird, das nacheinander das Implantieren von atomaren Spezies zur Schaffung einer Schwächungszone innerhalb des ersten Donorsubstrats, die die erste monokristalline halbleitende Schicht (2) begrenzt, das Kleben der Seite des ersten Donorsubstrats der ersten monokristallinen halbleitenden Schicht (2), die der Implantation unterzogen wurde, auf die erste elektrisch isolierende Schicht (1b) und das Brechen des ersten Donorsubstrats im Bereich der Schwächungszone umfasst.

7. Verfahren nach Anspruch 6, wobei der durch den Bruch entstandene Rest des ersten Donorsubstrats zur Bildung des zweiten Donorsubstrats verwendet wird.

8. Verfahren nach einem der Ansprüche 6 oder 7, wobei das Verfahren des Übertragens der ersten monokristallinen halbleitenden Schicht (2) von einem ersten Donorsubstrat auf die erste elektrisch isolierende Schicht (1b) ferner das Oxidieren der Oberfläche des ersten Donorsubstrats vor dem Implantieren von atomaren Spezies in das erste Donorsubstrat umfasst, wodurch eine erste schützende Oxidschicht derart gebildet wird, dass die atomaren Spezies durch die erste schützende Oxidschicht implantiert werden.

9. Verfahren nach Anspruch 8, wobei die auf der Oberfläche des ersten Donorsubstrats gebildete erste schützende Oxidschicht nach dem Implantieren der atomaren Spezies und vor dem Kleben des ersten Donorsubstrats auf die erste elektrisch isolierende Schicht (1b) entfernt wird.

10. Verfahren nach einem der Ansprüche 1 bis 9, wobei der Schritt des Übertragens der zweiten monokristallinen halbleitenden Schicht (3) von einem zweiten Donorsubstrat auf die zweite elektrisch isolierende Schicht (2b) nach einem Verfahren durchgeführt wird, das nacheinander das Implantieren von atomaren Spezies zur Schaffung einer Schwächungszone innerhalb des zweiten Donorsubstrats, die die zweite monokristalline halbleitende Schicht (3) begrenzt, das Kleben der Seite des zweiten Donorsubstrats der zweiten monokristallinen halbleitenden Schicht (3), die der Implantation unterzogen wurde, auf die zweite elektrisch isolierende Schicht (2b) und das Brechen des zweiten Donorsubstrats im Bereich der Schwächungszone umfasst.

11. Verfahren nach Anspruch 10, wobei das Verfahren des Übertragens der zweiten monokristallinen halbleitenden Schicht (3) von einem zweiten Donorsubstrat auf die zweite elektrisch isolierende Schicht (2b) ferner das Oxidieren der Oberfläche des zweiten Donorsubstrats vor dem Implantieren von atomaren Spezies in das zweite Donorsubstrat umfasst, wodurch eine zweite schützende Oxidschicht derart gebildet wird, dass die atomaren Spezies durch die zweite schützende Oxidschicht implantiert werden.

12. Verfahren nach Anspruch 11, wobei die auf der Oberfläche des zweiten Donorsubstrats gebildete zweite schützende Oxidschicht nach dem Implantieren der atomaren Spezies und vor dem Kleben des zweiten Donorsubstrats auf die zweite elektrisch isolierende Schicht (2b) entfernt wird.

13. Verfahren nach einem der Ansprüche 1 bis 12, das ferner einen Schritt des Durchführens eines Verfahrens der Behandlung der Oberfläche des ersten Substrats vom Typ Halbleiter-auf-Isolator Standard vor dem zweiten Schritt des Bildens einer Oxidschicht auf der Oberfläche dieses ersten Substrats vom Typ Halbleiter-auf-Isolator Standard umfasst, wobei das Verfahren zur Behandlung der Oberfläche **gekennzeichnet ist durch**:
- einen ersten Schritt des schnellen thermischen Glühens,
- einen zweiten Schritt der thermischen Oxidation, gefolgt von einer Desoxidation,
- einen dritten Schritt der längeren thermischen Behandlung oder einen dritten Schritt des schnellen thermischen Glühens, wobei die längere thermische Behandlung und das schnelle thermische Glühen bei einer Temperatur von über 1000°C in einer nicht oxidierenden Atmosphäre durchgeführt werden,
- einen vierten Schritt des mechanisch-chemischen Polierens.

14. Verfahren nach einem der Ansprüche 1 bis 13, wobei das Trägersubstrat und jedes Donorsubstrat in Form einer Platte mit einem Durchmesser von 300 mm vorliegen.

## Claims

1. Method for manufacturing a double semiconductor-on-insulator structure comprising, in succession from the rear face to the front face of the structure: a support substrate (1), a first electrically insulating layer (1b), a first monocrystalline semiconductor layer (2), a second electrically insulating layer (2b), and a second monocrystalline semiconductor layer (3), the method being **characterized in that** it comprises:
- a first step of forming an oxide layer on the front and rear faces of the support substrate (1) to form the first electrically insulating layer (1b) on the front face of the support substrate and an oxide layer (1a) on the rear face of the support substrate,
- a first layer transfer step for transferring the first single-crystal semiconductor layer (2) from a first donor substrate onto the first electrically insulating layer (1b), so as to form a first semiconductor-on-insulator substrate, which successively comprise, from the rear face to the front face of said first semiconductor-on-insulator substrate: the oxide layer (1a), the support substrate (1), the first electrically insulating layer (1b) and the first monocrystalline semiconductor layer (2),
- a second step of forming an oxide layer on the front side of the first semiconductor-on-insulator substrate to form the second electrically insulating layer (2b) and thicken the oxide layer (1a) on the rear side of the support substrate,
- a second layer transfer step for transferring the second single-crystal semiconductor layer (3) from a second donor substrate onto the second electrically insulating layer (2b), so as to form the double semiconductor-on-insulator substrate,
the oxide layer (1a) on the rear face of the support substrate contributing to the preservation of the flatness of the support substrate during the first and second transfer steps.

2. Method according to claim 1, wherein the thickness of the first electrically insulating layer (1b) is between 100 nm and 3000 nm.

3. Method according to any of claims 1 or 2, wherein the final double semiconductor-on-insulator structure obtained, the thickness of the first monocrystalline semiconductor layer (2) is between 50 nm and 500 nm.

4. Method according to any of claims 1 to 3, wherein the final double semiconductor-on-insulator structure obtained, the thickness of the second electrically insulating layer (2b) is between 100 nm and 1100 nm.

5. Method according to any of claims 1 to 4, wherein, in the final double semiconductor-on-insulator structure obtained, the thickness of the second monocrystalline semiconductor layer (3) is between 50 nm and 500 nm.

6. Method according to any of claims 1 to 5, wherein the step of transferring the first monocrystalline semiconductor layer (2) from a first donor substrate onto the first electrically insulating layer (1b) is carried out according to a process comprising, in succession: the implantation of atomic species in order to create a weakening zone within the first donor substrate delimiting the first monocrystalline semiconductor layer (2), bonding the face of the first donor substrate of the first monocrystalline semiconductor layer (2) that has undergone implantation onto the first electrically insulating layer (1b), and fracturing the first donor substrate at the embrittlement zone.

7. Method according to claim 6, wherein the remainder of the first donor substrate resulting from the fracture is used to form the second donor substrate.

8. Method according to any of claims 6 or 7, wherein the method of transferring the first monocrystalline semiconductor layer (2) from a first donor substrate onto the first electrically insulating layer (1b) further comprises oxidizing the surface of the first donor substrate prior to implanting atomic species into said first donor substrate, thereby forming a first protective oxide layer so that the atomic species are implanted through said first protective oxide layer.

9. Method according to claim 8, wherein the first protective oxide layer formed on the surface of the first donor substrate is removed after implantation of the atomic species and prior to bonding the first donor substrate to the first electrically insulating layer (1b).

10. Method according to any of claims 1 to 9, wherein the step of transferring the second monocrystalline semiconductor layer (3) from a second donor substrate onto the second electrically insulating layer (2b) is carried out according to a process comprising, in succession: the implantation of atomic species in order to create an weakening zone within the second donor substrate delimiting the second monocrystalline semiconductor layer (3), bonding the face of said second donor substrate of the second monocrystalline semiconductor layer (3) that has undergone implantation onto the second electrically insulating layer (2b) and fracturing the second donor substrate at the embrittlement zone.

11. Method according to claim 10, wherein the process of transferring the second monocrystalline semiconductor layer (3) from a second donor substrate onto the second electrically insulating layer (2b) further comprises oxidizing the surface of the second donor substrate prior to implanting atomic species into said second donor substrate, thereby forming a second protective oxide layer so that the atomic species are implanted through said second protective oxide layer.

12. Method according to claim 11, wherein the second protective oxide layer formed on the surface of the second donor substrate is removed after implantation of the atomic species and prior to bonding the second donor substrate to the second electrically insulating layer (2b).

13. Method according to any of claims 1 to 12, further comprising a step of implementing a process for treating the surface of the first semiconductor-on-insulator substrate prior to the second step of forming an oxide layer on the surface of this first semiconductor-on-insulator substrate, the surface treatment process being **characterized by**:
- a first step of rapid thermal annealing,
- a second step of thermal oxidation followed by deoxidation,
- a third step of long-duration thermal treatment or a third step of rapid thermal annealing, the long-duration thermal treatment and the rapid thermal annealing being carried out at a temperature above 1000°C in a non-oxidizing atmosphere,
- a fourth step of mechanical-chemical polishing.

14. Method according to any of claims 1 to 13, wherein the support substrate and each donor substrate are in the form of a plate with a diameter of 300 mm.
